Europäisches Patentamt

European Patent Office

Office européen des brevets

(19)

(11) Publication number: **0 241 853**
**A2**

# EUROPEAN PATENT APPLICATION

(21) Application number: **87105216.3**

(22) Date of filing: **08.04.87**

(51) Int. Cl.⁴: **G01R 31/34 , H02H 7/08**

(30) Priority: **12.04.86 JP 84746/86**
**12.04.86 JP 84747/86**
**12.04.86 JP 84748/86**

(43) Date of publication of application:
**21.10.87 Bulletin 87/43**

(84) Designated Contracting States:
**CH DE FR LI**

(71) Applicant: **NEC CORPORATION**
**33-1, Shiba 5-chome, Minato-ku**
**Tokyo 108(JP)**

(72) Inventor: **Kiyokazu, Okamoto c/o NEC**
**Corporation**
**33-1, Shiba 5-chome**
**Minato-ku Tokyo(JP)**
Inventor: **Hiroyuki, Oka c/o Nippon Elec.**
**Ind.Co.,Ltd.**
**19-18, Tsutsumi-dori 1-chome**
**Sumida-ku Tokyo(JP)**

(74) Representative: **Vossius & Partner**
**Siebertstrasse 4 P.O. Box 86 07 67**
**D-8000 München 86(DE)**

(54) **Apparatus for detecting abnormality of primary current for vector control.**

(57) In an apparatus for detecting abnormality of a primary current in vector control of an AC induction or synchronous motor whose rotator is rotated by a rotating field, signals representing an excitation current $i_d$ and a torque current $i_q$ and supplied to a vector control system are input to a microcomputer. An instantaneous value $I$, and RMS value $\overline{I}$, of the primary current of the motor is calculated for every predetermined time interval $\Delta T$. A calculated instantaneous value $I$, and RMS value $\overline{I}$, is compared with an allowable current value $I_0$ and $I_{rms}$ stored in a memory section in the microcomputer, respectively. A duration $T_{AA}$ for $I_1 \geqq I_0$ is monitored. If the duration $T_{AA}$ exceeds the allowable time $T_{A0}$ set in the memory section of the microcomputer, an abnormality signal is generated. And also, during $T_L$, the latest monitoring time, $\overline{I}$, $> I_{rms}$ is monitored. If $\overline{I}$, $> I_{rms}$ is true, another abnormality signal is generated. And moreover, $\overline{I}$, $_2$ versus $I_{2rms}$ is dealed with as $\overline{I}$, versus $I_{rms}$.

FIG. 1

## Apparatus for Detecting Abnormality of Primary Current for Vector Control

### Background of the Invention

The present invention relates to an apparatus for detecting abnormality of a primary current of an AC motor (e.g., an induction motor and a synchronous motor) for controlling vectors so as to prevent burning of the motor.

A thermal relay is generally used as a means for preventing an electric motor from burning due to an excessive current.

The thermal relay utilizes bimetal flexure caused by temperature changes and is used together with an electromagnetic contactor to turn on/off a driver or a control circuit.

A variable-voltage variable-frequency inverter has been popular as a power converter for variable speed control of an AC motor (an induction motor). The motor speed can be continuously changed in a wide speed range varying from a low speed to a very high speed.

Recently, a vector control AC motor has been developed (e.g., "New Drive Electronics", ed. Naohiko Ueyama, Denki Shoin Publishing Co.) and has been used in a variety of applications requiring high-precision speed control, high-precision position control, and abrupt acceleration or deceleration, of machine tools, robots, and the like.

An induction motor has the following advantages. The motor has a simple rotor structure and high mechanical strength. At the same time, the induction motor is brushless and thus can be used in a severe atmosphere, and the maintenance is simple. Therefore, induction motors have been a strong potential to be popular as servo motors in many industrial fields.

A conventional thermal relay is big size, expensive and bulky. In addition, the thermal relay is often kept at an ambient temperature different from that of the motor according to the location of the thermal relay, thereby degrading control precision.

Variable speed control of a servo motor as a drive source for a machine tool, a robot, or the like must be performed with high precision and requires a short response time. Under these circumstances, motor performance must be improved such that its failure must be detected on a real-time basis, and reduction of motor cost is also desirable. However, practical applications of a thermal protector (an apparatus for detecting abnormality of the primary current) satisfying the above needs have not yet come into being.

### Summary of the Invention

It is an object of the present invention to solve the above conventional problem and to provide an apparatus for highly precisely detecting abnormality of a primary current at high speed so as to protect an AC motor of a vector control system against an excessive current.

According to an aspect of the present invention, an apparatus for detecting abnormality of a primary current comprises means for converting levels of a DC excitation current $i_d$ and a DC torque current $i_q$, both of which are obtained through a coordinate converter for detecting control input data received by a vector control system, i.e., a primary current supplied to an AC motor and for converting three phases into two phases, means for A/D converting an output from the level converting means, and a microcomputer for fetching an output from the A/D converting means, processing it on the basis of predetermined processing, detecting abnormality of the primary current, and outputting an alarm signal.

According to another aspect of the present invention, a new function is realized. An apparatus for detecting abnormality of a secondary current in vector control of an induction motor is characterized in that signals of a secondary d-axis current $i_{2d}$ and a secondary q-axis current $i_{2q}$, both of which are extracted from a vector controller, are input to a microcomputer; an effective value $\overline{I}_2$ of a secondary current of the induction motor during the latest time $T_L$ is calculated for every given interval $\Delta T$ determined by monitoring time $T_L$ corresponding to an allowance and a thermal time constant of a secondary conductor, both of which are stored in a memory section of the microcomputer; the effective value $\overline{I}_2$ is compared with an allowable root-means-square (RMS) current $I_{2rms}$ corresponding to the secondary conductor thermal time constant and stored in the memory section; abnormality/normality of the secondary current is discriminated according to a comparison result; and an abnormality signal is generated when a discrimination result represents abnormality.

### Brief Description of the Drawings

Fig. 1 is block diagram showing the main arrangement of a vector control AC motor system which employs an apparatus for detecting abnormality of a primary current according to an embodiment of the present invention;

Fig. 2A is a circuit diagram of the apparatus shown in Fig. 1;

Fig. 2B is a graph showing changes in primary current as a function of time in the apparatus shown in Fig. 1;

Fig. 2C is a graph showing changes in primary current as a function of time so as to explain a monitoring duration $T_{AA}$;

Fig. 3 is a graph showing the relationship between the primary current instantaneous value and the excitation and torque currents;

Fig. 4A is a circuit diagram of an apparatus for detecting abnormality of a primary current according to another embodiment of the present invention;

Fig. 4B is a graph showing changes in primary current as a function of time in the apparatus shown in Fig. 4A;

Fig. 5 is a block diagram of a vector control induction motor system employing an apparatus for detecting abnormality of a secondary current according to still another embodiment of the present invention;

Fig. 6A is a circuit diagram of the apparatus shown in Fig. 5;

Fig. 6B is a graph showing changes in secondary current as a function of time in the apparatus of Fig. 5; and

Fig. 6C is a graph showing the relationship between the secondary current instantaneous value and the excitation and torque currents.

## Detailed Description of the Preferred Embodiments

Preferred embodiments of the present invention will be described in detail with reference to the accompanying drawings. For illustrative and descriptive convenience, an electric motor is exemplified by an induction motor (IM) but is not limited thereto. The present invention may also be applied to a synchronous motor.

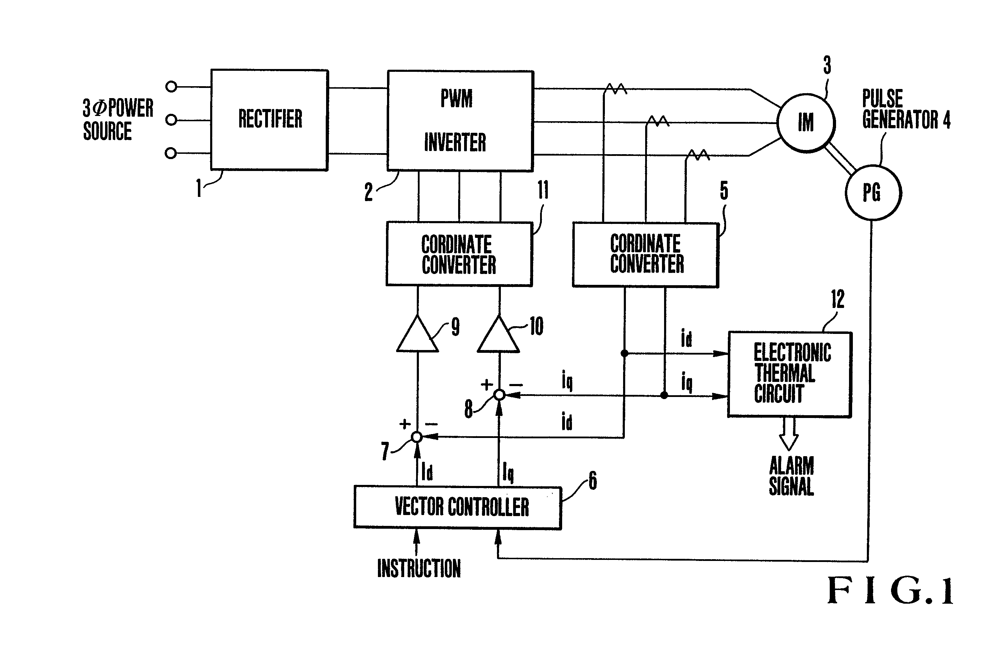

Fig. 1 shows a vector control AC induction motor system employing an apparatus for detecting abnormality of a primary current (i.e., an electronic thermal circuit).

Referring to Fig. 1, reference numeral 1 denotes a rectifier; 2, a PWM (Pulse Width Modulation) inverter; 3, an induction motor (IM); and 4, a pulse generator. A coordinate converter 5 detects a current supplied to the induction motor 3 and converts three phases into two phases. The coordinate converter 5 thus generates an excitation current $i_d$ and a torque current $i_q$. These currents are two-phase components of the primary current. A vector controller 6 receives an instruction signal and a feedback signal from the pulse generator 4 and generates an excitation current instruction $I_d$ and a torque current instruction $I_q$. Reference numeral 7 denotes an adder for adding the excitation current instruction $I_d$ and the excitation current $i_d$; and 8, an adder for adding the torque current instruction $I_q$ and the torque current $i_q$. Reference numerals 9 and 10 denote amplifiers, respectively. Reference numeral 11 denotes a coordinate converter for converting two phases into three phases. The coordinate converter 11 receives the d-and q-axis primary voltage components from the amplifiers 9 and 10 and supplies a control signal to the PWM inverter 2.

The overall system configuration of the above components is described in detail in, e.g., "Electric Equipment" 3.7.2, the Institute of Electric Engineers, Communication Training Committee, Japan, and refer to it for further details.

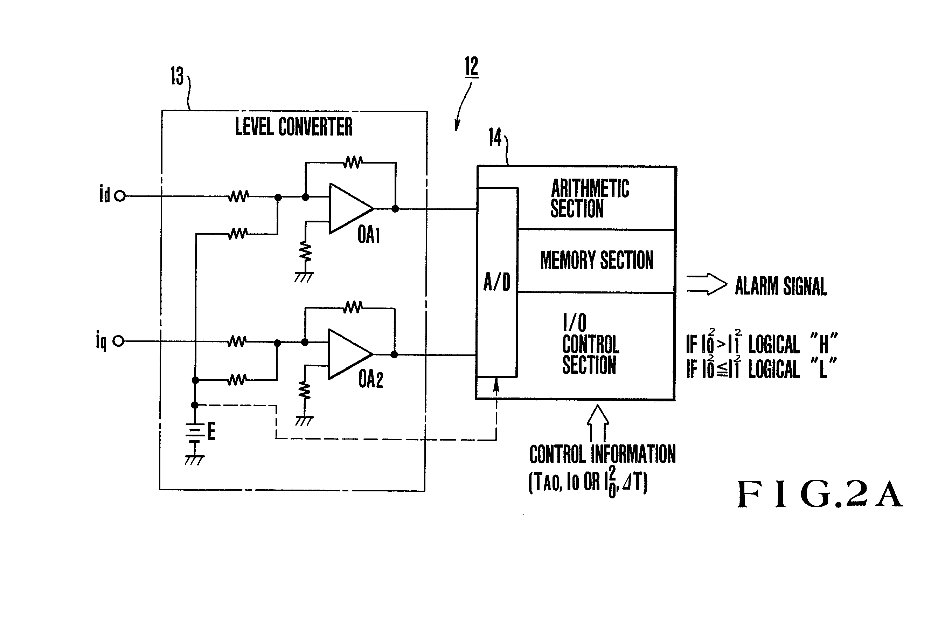

Fig. 2A is a circuit diagram of an apparatus for detecting abnormality of a primary current (an electronic thermal circuit) 12 according to an embodiment of the present invention.

Referring to Fig. 2A, the apparatus 12 comprises a level converter 13 and a microcomputer 14 with an A/D converter.

The level converter 13 offsets the excitation and torque currents $i_d$ and $i_q$ output from the coordinate converter 5 to the positive side since their signs are not determined to be positive or negative. The level converter 13 then converts the levels of the signals representing the excitation and torque currents $i_d$ and $i_q$ into the levels compatible with the microcomputer 14. The level converter 13 includes a DC power source E for generating an offset voltage and operational amplifiers OA1 and OA2.

The microcomputer 14 incorporates an A/D converter for converting an input signal into a digital signal and is exemplified by a μPD78PG11E. The microcomputer 14 includes an arithmetic section, a memory section, and an I/O control section. The memory section stores an allowable time $T_{A0}$, a given time interval $\Delta T$, an allowable current value $I_0$ (or $I_0^2$), and the like, all of which are set in correspondence with a thermal time constant of the primary winding and peripheral components thereof in the induction motor.

Data processing in the microcomputer 14 is as follows.

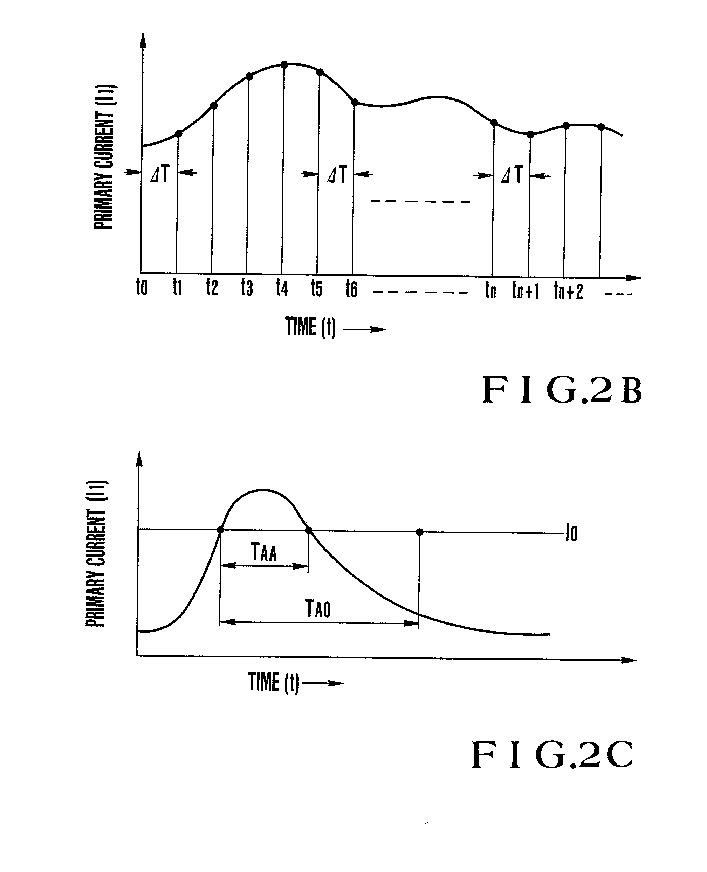

The positively offset signals representing the excitation and torque currents $i_d$ and $i_q$ are fetched by the microcomputer 14 through the level converter 13. Values $i_d^2$ and $i_q^2$ for every time interval $\Delta T$ as shown in Fig. 2B are calculated and added to each other to obtain $I_1^2$. As shown in Fig. 2C, the calculated value $I_1^2$ is compared with the allowable current value $I_0^2$ set in correspondence with the thermal time constant of the primary winding. The microcomputer 14 then measures or counts a duration $T_{AA}$ in which condition $I_i^2 \geqq I_o^2$ is established. If the monitored time $T_{AA}$ exceeds the allowable time $T_{A0}$ stored in the memory section of the microcomputer, an abnormality signal (an alarm signal) is generated. In response to the abnormality signal, the drive power is withdrawn from the motor or an abnormality alarm is generated.

The value of the allowable time $T_{A0}$ is set in correspondence with the thermal time constant (the allowable temperature rise) of the primary winding and peripheral components thereof in the induction motor. By using the excitation and torque currents $i_d$ and $i_q$ as the components of the primary current, the instantaneous value $I_i$ of the primary current supplied to the induction motor is calculated on a real-time basis to determine whether the calculated value falls within the range of the allowable current pattern shown in Fig. 2C.

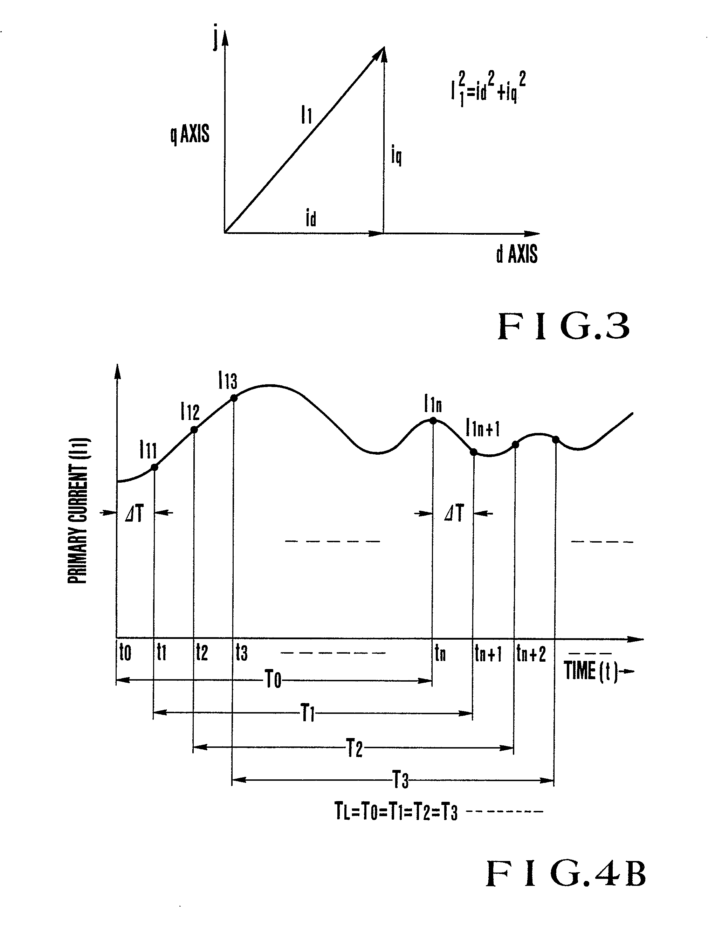

The relationship between the primary current $I_i$ of the induction motor and the excitation and torque currents $i_d$ and $i_q$ of the input data is shown in Fig. 3. More specifically, the primary current $I_i$ can be simply calculated by relation $I_i^2 = i_d^2 + i_q^2$.

Fig. 4A shows an apparatus 12 in Fig. 1 for detecting abnormality of a primary current according to another embodiment of the present invention.

Referring to Fig. 4A, the apparatus 12 comprises a level converter 13 and a microcomputer 14 with an A/D converter.

The level converter 13 offsets the excitation and torque currents $i_d$ and $i_q$ output from the coordinate converter 5 since their signs are not determined to be positive or negative to the positive side. The level converter 13 then converts the levels of the signals representing the excitation and torque currents $i_d$ and $i_q$ into the levels compatible with the microcomputer 14. The level converter 13 includes a DC power source E for generating an offset voltage and operational amplifiers OA1 and OA2.

The microcomputer 14 incorporates an A/D converter for converting an input signal into a digital signal and is exemplified by a $\mu$PD78PG11E. The microcomputer 14 includes an arithmetic section, a memory section, and an I/O control section. The memory section stores a monitoring time $T_L$, a given time interval $\Delta T$, an allowable RMS current $I_{rms}$ (or $I^2_{rms}$), and the like, all of which are set in correspondence with a thermal time constant of the primary winding and peripheral components thereof in the induction motor.

Data processing in the microcomputer 14 is as follows.

The positively offset signals representing the excitation and torque currents $i_d$ and $i_q$ are fetched by the microcomputer 14 through the level converter 13. Values $i_d^2$ and $i_q^2$ for every time interval

$\Delta T$ are calculated and added to each other to obtain $I_i^2$. An average value $\Sigma I_i^2/T_L$ during the latest monitoring time $T_L$ ($T_0$, $T_1$, $T_2$,...) is calculated. The calculated value $\Sigma I_i^2/T_L$ is compared with the allowable RMS current $I^2_{rms}$. If $I^2_{rms} \leqq \Sigma I_i^2/T_L$, then an alarm tone is produced. However, if $I^2_{rms} > \Sigma I_i^2/T_L$, then the value $\Sigma I_i^2/T_L$ is retained and data processing is repeated. Every time $I_i^2$ after the lapse of $\Delta T$ is calculated, a new $I_i^2$ value is added to the sum. At the same time, the oldest $I_i^2$ is subtracted from the updated sum. The average value calculated from the updated sum is then compared with the current $I_{rms}$.

In the above data processing, the RMS current $\overline{I}_i$ is calculated in the form of a square, i.e., $I_i^2$. The value $\overline{I}_i^2$ can be used without modifications and can be compared with the square of the RMS current $I_{rms}$ to discriminate abnormality/normality. Therefore, extraction of a square root can be omitted to improve arithmetic efficiency.

The RMS primary current $\overline{I}_i$ of the motor during the latest time $T_L$ is calculated for every given interval T determined by the allowance and the thermal time constant of the primary winding and the peripheral components thereof, as shown in Fig. 4B. In this case, the allowance and the thermal time constant are stored in the memory section in the microcomputer. The calculated RMS primary current $\overline{I}_i$ is compared with the allowable RMS current $I_{rms}$ corresponding to a thermal time constant of the primary winding and the peripheral components thereof. The thermal time constant is also stored in the memory section in the microcomputer. Normality/abnormality is discriminated according to the sign represented by the comparison result. If the comparison result represents abnormality, an abnormality signal (i.e., an alarm signal) is generated. In response to the alarm signal, the drive power is withdrawn from the electric motor, or an abnormality tone is produced.

The value of the given time interval $\Delta T$ is selected as follows. The number of samples is determined by the allowance and the monitoring time $T_L$. If the allowance is n%, the value of the interval $\Delta T$ is given as n/100 $\times$ $T_L$ $\times$ K (where K = 0.3 to 3). As a result, the RMS primary current $I_i$ during the latest monitoring time $T_L$ (= $T_0$, $T_1$, $T_2$,...) is calculated for every predetermined time interval T to constantly monitor whether the calculated value exceeds the allowable RMS current $I_{rms}$.

The relationship between the primary current $\overline{I}_i$ and the excitation and torque currents $i_d$ and $i_q$ of the input data is shown in Fig. 3. The RMS primary current $\overline{I}_i$ can be simply calculated by relation $I_i^2 = i_d^2 + i_q^2$.

In the apparatus for detecting abnormality of a primary current for vector control according to the two embodiments as described above, abnormality detection of the AC motor and a countermeasure therefor can be highly precisely performed at high speed. At the same time, the apparatus can be made compact and is inexpensive.

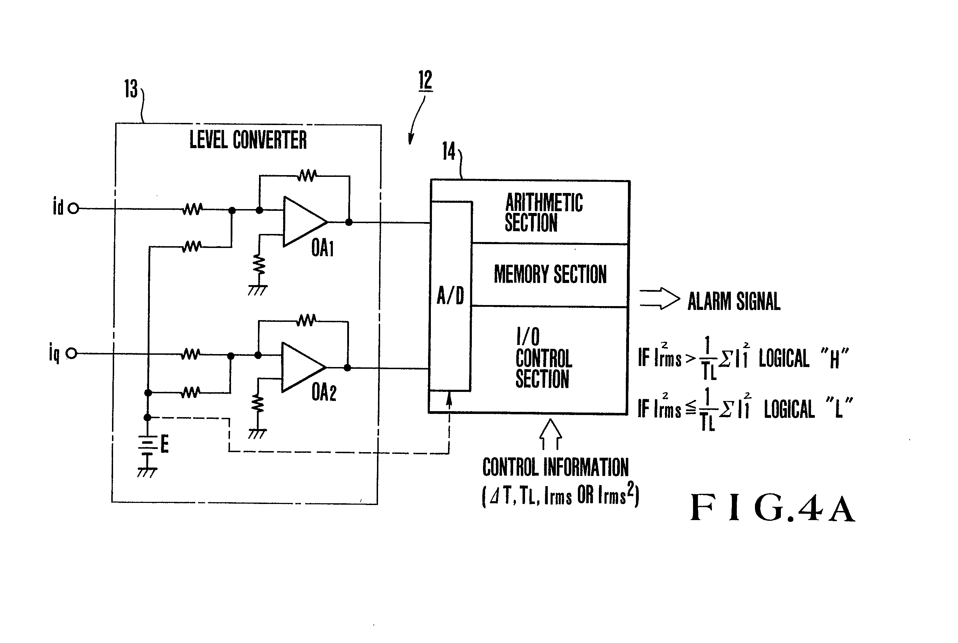

Fig. 5 shows the main part of a vector control induction motor system which employs an apparatus for detecting abnormality of a secondary current according to still another embodiment of the present invention. This function cannot be realized by conventional means such as the thermal relay, because the secondary current cannot be picked up directly.

Referring to Fig. 5, reference numeral 1 denotes a rectifier; 2, a PWM inverter; 3, an induction motor (IM); 40, a speed sensor (SS); and 50, a vector controller. Reference numeral 60 denotes an apparatus for detecting abnormality of the secondary current according to this embodiment.

The vector controller 50 uses a detection signal of a primary current supplied to the induction motor as well as a feedback signal, a control instruction, and the like from the speed sensor (SS) and generates the secondary d-and q-axis currents $i_{2d}$ and $i_{2q}$. These currents $i_{2d}$ and $i_{2q}$ are input to the electronic thermal circuit.

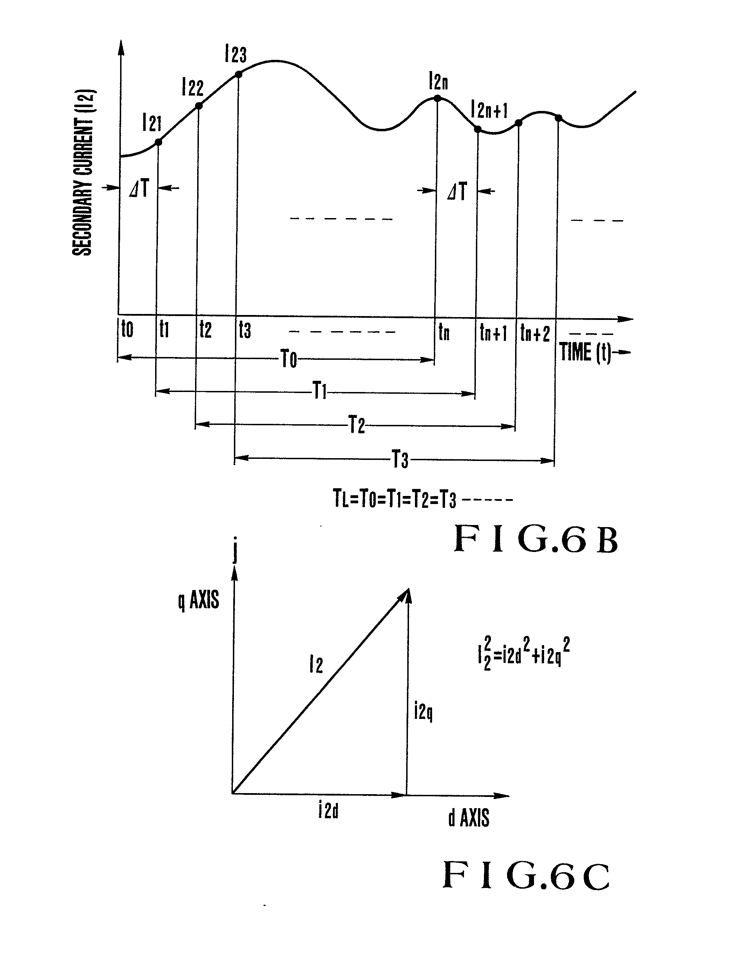

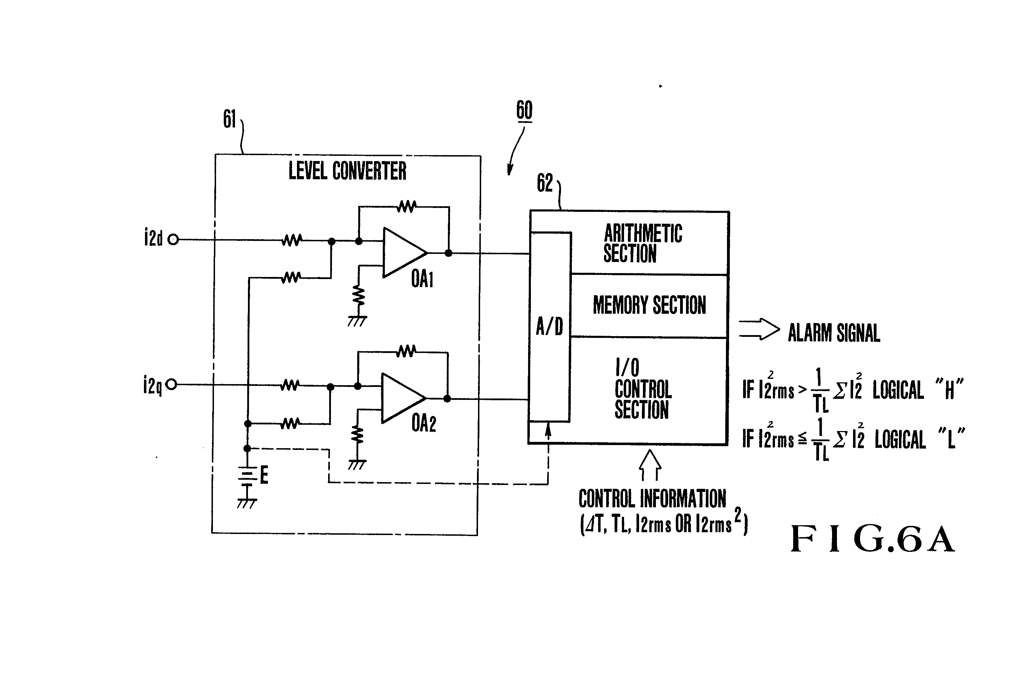

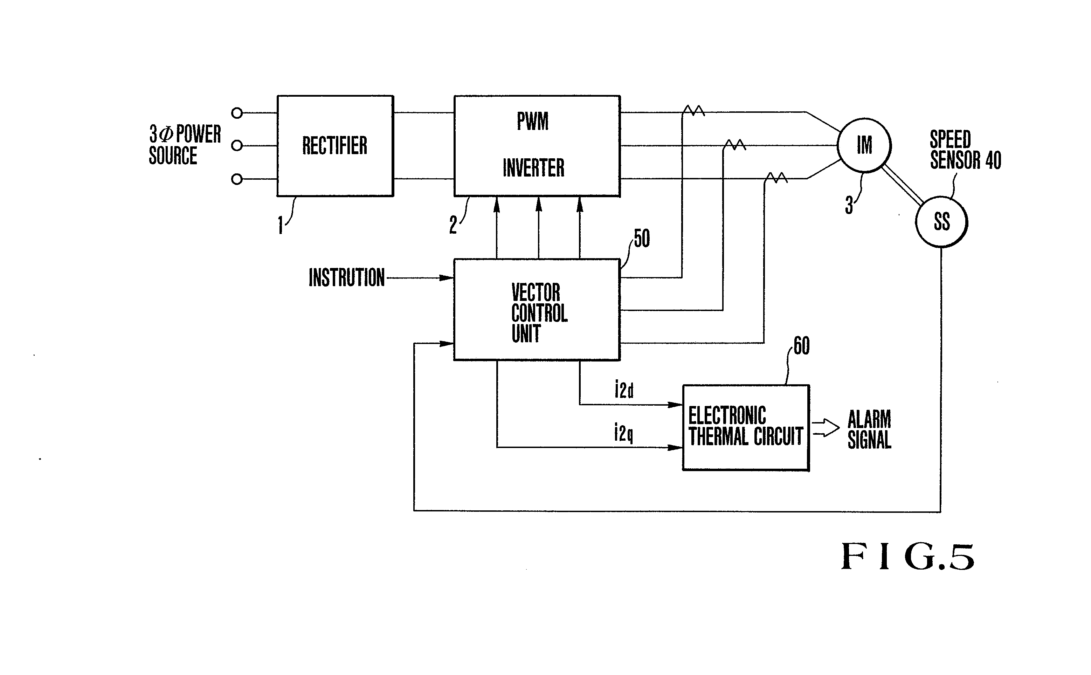

Fig. 6A shows the detailed arrangement of the apparatus 60 shown in Fig. 5. Referring to Fig. 6A, the electronic thermal circuit 60 comprises a level converter 61 and a microcomputer 62 with an A/D converter which have same hardware as used in the apparatus shown in Fig. 4A.

The level converter 61 offsets secondary d-and q-axis excitation and torque currents i $_{2d}$ and $i_{2q}$ output from the vector converter 50 to the positive side since their signs are not determined to be positive or negative. The level converter 61 then converts the levels of the signals representing the excitation and torque currents $i_{2d}$ and $i_{2q}$ into the levels compatible with the microcomputer 62. The level converter 61 includes a DC power source E for generating an offset voltage and operational amplifiers OAI and OA2.

The microcomputer 62 incorporates an A/D converter for converting an input signal into a digital signal and is exemplified by a μPD78PG11E. The microcomputer 62 includes an arithmetic section, a memory section, and an I/O control section. The memory section stores a monitoring time $T_L$, a given time interval $\Delta T$, an allowable RMS current $I_{rms}$ (or $I^2_{rms}$), and the like, all of which are set in correspondence with a thermal time constant of the secondary conductor or winding in the induction motor.

Data processing in the microcomputer 62 is as follows.

The positively offset signals representing the secondary d-and q-axis excitation and torque currents $i_{2d}$ and $i_{2q}$ and extracted by the vector controller 50 are fetched by the microcomputer 62 through the level converter 61. Values $i_d^2$ and $i_q^2$ for every time interval $\Delta T$ are calculated and added to each other to obtain $I_2^2$. An average value $\Sigma I_2^2/T_L$ which shows an effective value, i.e., a RMS secondary current $I_2$ during the latest monitoring time $T_L$ ($T_0$, $T_1$, $T_2$,...) is calculated. The calculated value $\Sigma I_2^2/T_L$ is compared with the allowable RMS current $I_{2rms}$. If $I_{2rms}^2 \leq \Sigma I_2^2/T_L$, then an alarm tone is produced. However, if $I_{2rms}^2 > \Sigma I_2^2/T_L$ then the value $\Sigma I_2^2/T_L$ is retained and data processing is repeated. Every time $I_2^2$ after the lapse of $\Delta T$ is calculated, a new $I_2^2$ value is added to the sum. At the same time, the oldest $I_2^2$ is subtracted from the updated sum. The average value calculated from the updated sum is then compared with the current $I_{2rms}^2$.

In the above data processing, the secondary RMS current $\overline{I}_2$ is calculated in the form of a square, i.e., $\overline{I}_2^2$. The value $I_2^2/T_L$ can be used without modifications and can be compared with the square of the RMS current $I_{2rms}$ to discriminate abnormality/normality. Therefore, extraction of a square root can be omitted to improve arithmetic efficiency.

The value of the given time interval $\Delta T$ is selected as follows. The number of samples is determined by the allowance and the monitoring time $T_L$. If the allowance is n%, the value of the interval $\Delta T$ is given as n/100 $\times$ $T_L$ $\times$ K (where K = 0.3 to 3). The number of samples is a value corresponding to $T_L/\Delta T$.

In the apparatus for detecting abnormality of a secondary current according to the present invention, the secondary RMS current $\overline{I}_2$ during the latest monitoring time $T_L$ (= $T_0$, $T_1$, $T_2$,...) is calculated for every predetermined time interval $\Delta T$ to constantly monitor whether the calculated value exceeds the allowable RMS current $I_{2rms}$.

The secondary current $I_2$ can be calculated as follows:
$$I_2 = -1/R^2(d\phi_2/dt + j\omega_s \bullet \phi_2) = i_{2d} + ji_{2q}$$
where

$R_2$: the secondary resistance of the induction motor

$\phi_2$: the secondary interlinkage of the induction motor

$\omega_s$: the slip angular frequency

The secondary d-axis current $i_{2d}$, the secondary q-axis current $i_{2q}$, and the secondary current $I_2$ satisfy the relationship shown in Fig. 6B, and the secondary current $I_2$ can be easily calculated as follows:
$$I_2^2 = i_{2d}^2 + i_{2q}^2$$

In the apparatus for detecting abnormality of the secondary current for vector control according to the above embodiment as described above, abnormality detection of the vector control AC motor and a countermeasure thereof can be highly precisely performed at high speed. In addition, the apparatus can be made compact and is inexpensive.

## Claims

1. An apparatus for detecting abnormality of a primary current in vector control of an AC induction or synchronous motor whose rotator is rotated by a rotating field, wherein signals representing an excitation current $i_d$ and a torque current $i_q$ and supplied to a vector control system are input to a microcomputer; an instantaneous value $I_1$ of the primary current of the motor is calculated for every predetermined time interval $\Delta T$; a calculated instantaneous value $I_1$ is compared with an allowable current value $I_0$ stored in a memory section in said microcomputer; a duration $T_{AA}$ for $I_1 \geq I_0$ is monitored; and if the duration $T_{AA}$ exceeds the allowable time $T_{A0}$ set in said memory section of said computer, an abnormality signal is generated.

2. An apparatus according to claim 1, wherein a value of the allowable time $T_{A0}$ is set in correspondence with a thermal time constant of a primary winding and peripheral components thereof in the motor.

3. An apparatus for detecting abnormality of a primary current in vector control of an AC induction or synchronous motor whose rotator is rotated by a rotating field, wherein signals representing an excitation current $i_d$ and a torque current $i_q$ and supplied to a vector control system are input to a microcomputer; a primary root-mean-square current $\overline{I}_1$ of the motor during the latest time $T_L$ is calculated for every predetermined time interval $\Delta T$ determined by a monitoring time $T_L$ corresponding to an allowance and a thermal time constant of a primary winding and peripheral components thereof, the allowance and the thermal time constant being stored in a memory section of said microcomputer; a calculated primary root-mean-square current $\overline{I}_1$ is compared with an allowable root-mean-square current $I_{rms}$ corresponding to the thermal time constant of the primary winding and peripheral components thereof and stored in said memory section in said microcomputer; abnormality/normality is discriminated according to a sign of a comparison result; and if a discrimination result represents abnormality, an abnormality signal is generated.

4. An apparatus according to claim 3, wherein the number of samples is a value corresponding to $T_L/\Delta T$.

5. An apparatus according to claim 3 or 4, wherein a value of the predetermined time interval $\Delta T$ is selected to be $n/100 \times T_L \times K$ (where $K = 0.3$ to 3) if the number of samples is determined by the allowance and the monitoring time $T_L$ and the allowance is n%.

6. An apparatus for detecting abnormality of a secondary current in vector control of an induction motor, wherein signals of a secondary d-axis current $i_{2d}$ and a secondary q-axis current $i_{2q}$, both of which are extracted from a vector controller, are input to a microcomputer; a secondary root-mean-square current $\overline{I}_2$ the induction motor during the latest time $T_L$ is calculated for every given interval $\Delta T$ determined by monitoring time $T_L$ corresponding to an allowance and a thermal time constant of a secondary conductor, both of which are stored in a memory section of said microcomputer; the effective value $\overline{I}_2$ is compared with an allowable root-means-square (RMS) current $I_{2rms}$ corresponding to the secondary conductor thermal time constant and stored in said memory section;
abnormality/normality of the secondary current is discriminated according to a comparison result; and an abnormality signal is generated when a discrimination result represents abnormality.

7. An apparatus according to claim 6, wherein the number of samples is a value corresponding to $T_L/\Delta T$.

8. An apparatus according to claim 6 or 7, wherein a value of the predetermined time interval $\Delta T$ is selected to be $n/100 \times T_L \times K$ (where $K = 0.3$ to 3) if the number of samples is determined by the allowance and the monitoring time $T_L$ and the allowance is n%.

FIG.1

FIG.2A

IF $I_0^2 > I_1^2$ LOGICAL "H"
IF $I_0^2 \leqq I_1^2$ LOGICAL "L"

CONTROL INFORMATION
($T_{A0}$, $I_0$ OR $I_0^2$, $\Delta T$)

F I G.2 B

F I G.2 C

$$I_1^2 = i_d^2 + i_q^2$$

**FIG.3**

$$TL = T_0 = T_1 = T_2 = T_3 \text{ --------}$$

**FIG.4B**

F I G.4A

0 241 853

SECONDARY CURRENT (I2)

I23

I22

I21

I2n

I2n+1

$\Delta T$

$\Delta T$

t0  t1  t2  t3 — — — — — tn  tn+1  tn+2  — — —

TIME (t)→

T0

T1

T2

T3

$TL=T0=T1=T2=T3 -----$

# F I G . 6 B

j

q AXIS

I2

$I_2^2 = i2d^2 + i2q^2$

i2q

i2d

d AXIS

# F I G . 6 C

**LEVEL CONVERTER** — 61

60

62

i2d

OA1

i2q

OA2

E

A/D

**ARITHMETIC SECTION**

**MEMORY SECTION**

**I/O CONTROL SECTION**

$\Rightarrow$ **ALARM SIGNAL**

IF $I2rms^2 > \dfrac{1}{TL}\Sigma I2^2$ LOGICAL "H"

IF $I2rms^2 \leqq \dfrac{1}{TL}\Sigma I2^2$ LOGICAL "L"

**CONTROL INFORMATION**
($\Delta T$, TL, I2rms OR I2rms$^2$)

# F I G.6A

0 241 853

FIG.5

0 241 853